# EUROPEAN PATENT APPLICATION

(11) **EP 1 971 027 A1**
(43) Date of publication of application: **17.09.2008**
(21) Application number: 07005167.7
(22) Date of filing: 13.03.2007
(51) Int. Cl.: H03J 1/00, G01R 23/16

(54) **Hand-held spectrum scanner**

(71) Applicant: MARK STAR Servo-tech Co., Ltd., Yilan County 260 Yilan City, Tawain (CN)
(72) Inventor: Chen, Chih-Feng, Yilan City Yilan County 260 Taiwan (CN)
(74) Representative: Becker, Eberhard

(57) **Abstract**

A handheld spectrum scanner comprises a radio module, a central processing unit (CPU), a display module, a power module for supplying power, and a switch setting module acting as controlling interfaces for inputting scan conditions. The radio module comprises an antenna, a filter amplifier, a transducer and a demodulator. The antenna receives frequency signals of wireless electric waves. The filter amplifier amplifies the frequency signals. The transducer and the demodulator analyze energy of the frequency signals and output the scanned result to the CPU. The CPU compares the variation of the voltage level of the scanned result from the radio module based on scan conditions input by the switch selling module, and outputs the determined result. The display module has a display for displaying the determined result from the CPU.

## Description

### BACKGROUND OF THE INVENTION

### (a) Field of the Invention

The present invention pertains to a handheld spectral scanner, and particularly to a handheld spectral scanner which is portable for detecting ambient frequencies, whereby a remote controller determines occurrence of interferences of wireless electric waves within the same spectrum, and correspondingly converts frequency.

### (b) Description of the Prior Art

Wireless transmission technology is developed well and is employed extensively contemporarily. Wireless communication, wireless network and wireless signal transmission etc. are performed through wireless electric waves. For wireless transmission devices, a variety of frequency bands of wireless electric waves are in existence in ambient environment. A wireless transmission device tends to operate inaccurately, distort or interfere provided that it happens to interferential wireless electric waves. Quality and intensity of wireless electric waves directly affect performance of receiving terminals.

### SUMMARY OF THE INVENTION

In view of the above, a main object of the present invention is to provide a handheld spectrum scanner which is portable to precisely display scanned result with a liquid display or a kinescope display for users' reference and which is able to full-frequency scan.

Another object of the present invention is to provide a handheld spectrum scanner which can display with liquid crystal display (LCD) display or kinescope display of various portable devices by means of connection lines transmission or wireless transmission.

A handheld spectrum scanner in accordance with the present invention is able to full-frequency scan, and comprises a radio module, a central processing unit (CPU), a display module, a power module and a switch setting module. The radio module comprises an antenna for receiving ambient frequency signals, a filter amplifier, a transducer and a demodulator. The antenna receives frequency signals of wireless electric waves. The filter amplifier amplifies the frequency signals. The transducer and the demodulator analyze energy of the frequency signals and output to the CPU. The CPU compares variation of voltage level of the scanned result from the radio module based on scan conductions inputted by the switch setting module, and outputs determined result to the display module for users' reference. The display module has a LCD display on a housing of the spectrum scanner for displaying the determined result from the CPU with diverse graphics and characters. The power module supplies power for all modules of the handheld spectrum scanner. The switch setting module includes buttons with multiple functions acting as controlling interfaces for individually setting scan conditions which comprise scanning frequency, warning frequency band, warning level, attenuation volume, power controlling and screen contrast etc.

### BRIEF DESCRIPTION OF THE DRAWINGS

Fig. 1 is a block diagram of a circuit of a handheld spectrum scanner according to the present invention.
Fig. 2 is a perspective view of the handheld spectrum scanner according to the present invention.
Fig. 3 conceptually shows the handheld spectrum scanner being used.
Fig. 4 is a perspective view of the handheld spectrum scanner, wherein a power module is disassembled.

### DETAILED DESCRIPTION OF THE PREFERRED EMBODIMENTS

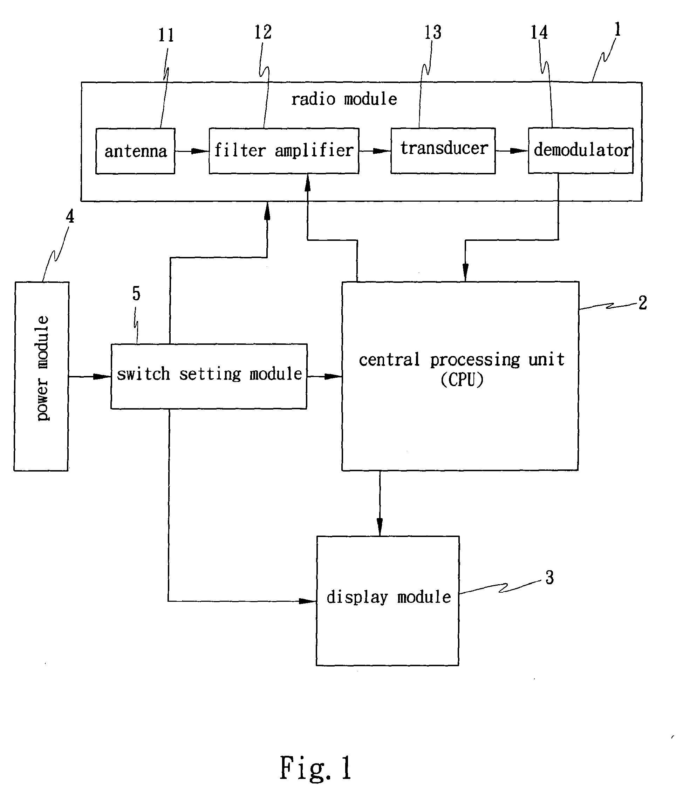

With reference to Fig. 1, a handheld spectrum scanner in accordance with the present invention comprises a radio module 1, a central processing unit (CPU) 2, a display module 3, a power module 4 and a switch setting module 5.

The radio module 1 comprises an external antenna 11, a filter amplifier 12, a transducer 13 and a demodulator 14. The antenna 11 receives frequency signals of ambient wireless electric waves. The filter amplifier 12 amplifies the frequency signals. The transducer 13 and the demodulator 14 analyze energy of the frequency signals, and output scanned result to the CPU 2.

Based on scan conductions inputted by the switch setting module 5, the CPU 2 compares variation of voltage level of the scanned result from the radio module 1, and outputs the determined result to the display module 3 for users' reference.

The display module 3 has a LCD (Liquid Crystal Display) display on a housing (not labeled) of the spectrum scanner for displaying the determined result from the CPU 2 with diverse graphics and characters. The display module 3 may operate by means of connection lines transmission or wireless transmission. Any LCD display or kinescope display of various portable devices, for example Notebook computers, mobile phones or PDA (Personal Digital Assistant), can be used to display the determined result from the CPU 2.

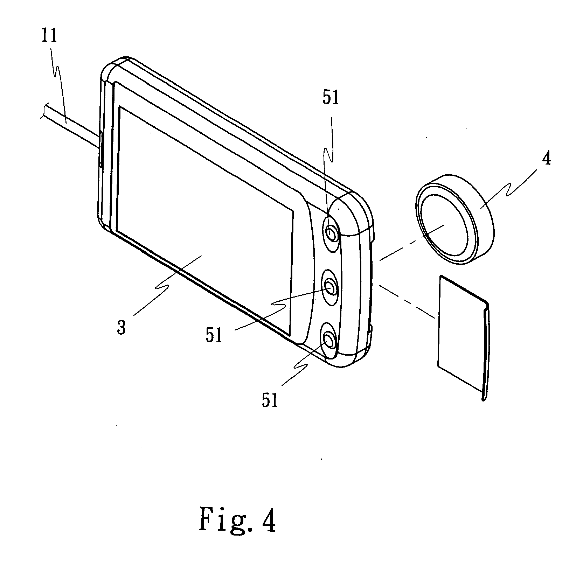

As can be seen from Figs. 1 and 4, the power module 4 supplies power for all modules of the handheld spectrum scanner.

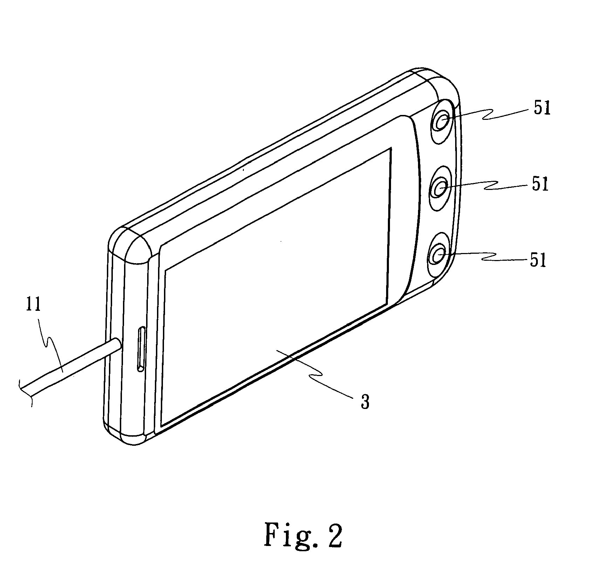

The switch setting module 5 includes buttons 51 (shown in Fig. 2) acting as controlling interfaces for individually setting scan conditions, such as scanning frequency, warning frequency band, warning level, attenuation volume, power controlling and screen contrast etc. The buttons 51 are formed on the housing of the spectrum scanner and have multiple functions.

Owing to the spectrum scanner, a user can rapidly and properly view the determined result from a display. The spectrum scanner facilitates remote controllers (not shown) to guard from interferential wireless electric waves and further to lock specific frequency band which are not interfered during electric waves are transmitted.

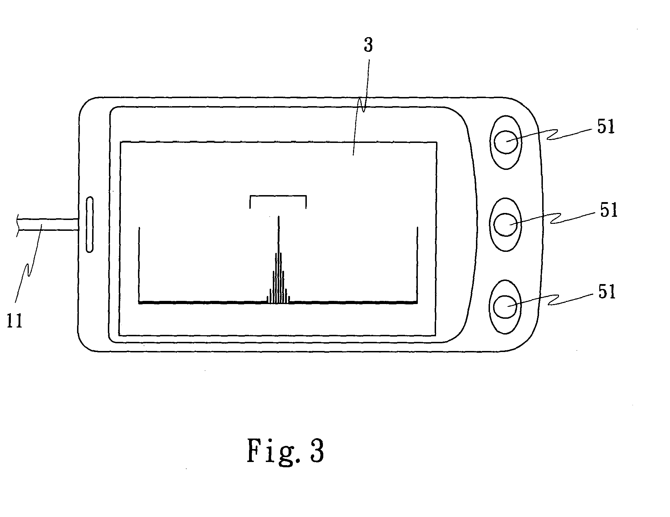

Referring to Fig. 3, in use, before a remote controller (not shown) is powered on, a button 51, for example the middle button 51, is selected to power on the spectrum scanner. The spectrum scanner automatically enters scanning mode. The selected button 51 (the middle button 51) is pressed again to enter a setting page. Frequency options and frequency band options can be adjusted to consist with those of the remote controller. Then the spectrum scanner returns to a working page, and starts to scan. An energy column list is generated on the display. The user needs to confirm that the energy volume graph is set as desired frequency. If detected frequencies are the same as current frequency which is being used by the user's device, the user may change the current frequency to a frequency which is different from the detected frequencies. The buttons 51 may be selected to serve as up key and down key for looking for the energy column list. The current frequency which is being used can be read at an upper portion of the energy column list. The user may replace the current frequency with any other new frequency which differs from the detected frequency, and may press an OK key to confirm. Then the power of the remote controller is turned on, the user can read the energy column list at the new frequency.

Other displays, instead of the LCD display on the housing of the handheld spectrum scanner, may act as the display of the present invention by means of connection lines transmission or wireless transmission. The determined result from the CPU 2 may be transferred to other LCD display or kinescope display on other portable devices, for example notebook, mobile phone, PDA etc.

It is understood that the invention may be embodied in other forms without departing from the spirit thereof. Thus, the present examples and embodiments are to be considered in all respects as illustrative and not restrictive, and the invention is not to be limited to the details given herein.

## Claims

1. A handheld spectrum scanner comprising:
a radio module comprising an antenna for receiving frequency signals of wireless electric waves, a filter amplifier for amplifying the frequency signals, and a transducer and a demodulator for analyzing energy of the frequency signals and outputting scanner result;
a central processing unit (CPU) comparing variation of voltage level of the scanned result from the radio module based on scan conductions, and outputting determined result for reference;
a display module having a display for displaying the determined result from the CPU with diverse graphics and characters;
a power module supplying power; and
a switch setting module including buttons with multiple functions, the buttons acting as controlling interfaces for individually setting scan conditions which comprise scanning frequency, warning frequency band, warning level, attenuation volume, power controlling and screen contrast etc.

2. The handheld spectrum scanner as claimed in claim 1, wherein the display of the display module is a liquid crystal display (LCD) display on a housing of the handheld spectrum scanner.

3. The handheld spectrum scanner as claimed in claim 1, wherein the display module operates by means of connection lines transmission or wireless transmission, and displays with a display of various portable devices.

4. The handheld spectrum scanner as claimed in claim 3, wherein the display module displays with an LCD display.

5. The handheld spectrum scanner as claimed in claim 3, wherein the display module displays with a kinescope display.

6. The handheld spectrum scanner as claimed in claim 1 capable of full-frequency scanning.
